# EUROPEAN PATENT APPLICATION

(11) **EP 1 622 194 A1**
(43) Date of publication of application: **01.02.2006**
(21) Application number: 04727121.8
(22) Date of filing: 13.04.2004
(51) Int. Cl.: H01L 21/316, H01L 21/336, H01L 29/78

(54) **SEMICONDUCTOR DEVICE AND PROCESS FOR PRODUCING THE SAME**

(30) Priority: 18.04.2003 JP 2003114616
(71) Applicant: OHMI, Tadahiro, Sendai-shi, Miyagi 980-0813 (JP)
(72) Inventor: OHMI, Tadahiro, Sendai-shi, Miyagi 9800813 (JP); TERAMOTO, Akinobu, Sendai-shi, Miyagi (JP)
(74) Representative: Glawe, Delfs, Moll
(86) International application number: PCT/JP2004/005230
(87) International publication number: WO 2004/095562

(57) **Abstract**

A semiconductor device comprising a substrate of SiC provided with an insulating film through plasma treatment. Rare gas is incorporated in the insulating film. Preferably, at least one of krypton (Kr), argon (Ar) and xenon (Xe) is used as the rare gas. A combination of oxygen gas and krypton (Kr) is especially preferred.

## Description

### Technical Field

This invention relates to a method of forming an insulating film on a semiconductor substrate and to a manufactured device.

### Background Art

Generally, Si (silicon) is used as substrates forming semiconductor devices. On the other hand, SiC having a withstand voltage about ten times greater than that of silicon is considered effective for power devices and so on. International Publication No. W097/39476 discloses a SiC element applicable to a semiconductor element of a high-power device, a high-temperature device, an environment-resistant device, or the like and a manufacturing method thereof.

However, SiC has a hexagonal structure and thus has no plane corresponding to a (100) plane of silicon and, when an insulating film is formed by a conventional heat-treatment method, interface states significantly increase to degrade device properties.

### Disclosure of the Invention

This invention has been made in view of the foregoing circumstances and has an object to provide a method capable of forming an insulating film that is excellent in all plane orientations.

A semiconductor device according to a first mode of this invention comprises a semiconductor substrate made of SiC and an insulating film formed on the semiconductor substrate. The insulating film is formed by a plasma treatment and contains a rare gas at least partly.

According to this invention, it becomes possible to form an insulating film excellent in all plane orientations. As a result, it becomes possible to manufacture a semiconductor device that can suppress an increase in interface states and has excellent device properties. The semiconductor device of this invention is particularly suitable for a power device requiring a high withstand voltage and enables a thickness of the insulating film of about 300nm (=3000Å) without degrading the device properties.

Preferably, at least one of krypton (Kr), argon (Ar), and xenon (Xe) is contained as the rare gas. Particularly, a combination of an oxygen gas and krypton (Kr) is preferable. This is because oxygen radicals and krypton (Kr) during film formation remain in a formed oxide film to thereby improve the properties (insulating property, interface property) as the insulating film. Note that, in the case of a thermal oxidation technique, krypton (Kr) does not remain in an oxide film.

The insulating film can be formed by direct oxidation, direct nitriding, or direct oxynitriding of a microwave-excited plasma or can be formed by oxidation, nitriding, or oxynitriding by microwave-excited plasma CVD (Chemical Vapor Deposition). Alternatively, when formation of an oxide film (nitride film, oxynitride film) by CVD is carried out after direct oxidation (nitriding, oxynitriding), it is possible to easily increase the thickness of the insulating film.

In a semiconductor device manufacturing method according to a second mode of this invention, an insulating film is formed by a plasma treatment on a semiconductor substrate made of SiC.

### Brief Description of the Drawings

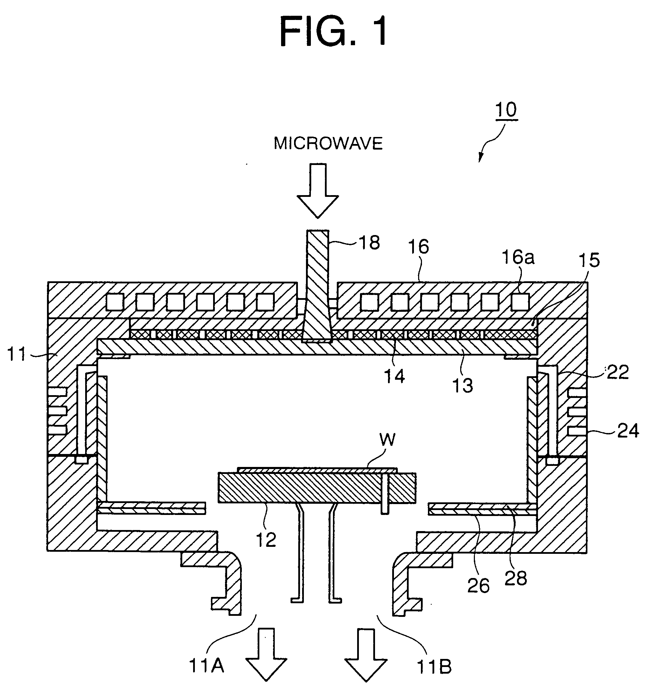

Fig. 1 is a schematic diagram (sectional view) showing a structure of a plasma treatment apparatus for use in this invention.

### Best Mode for Carrying Out the Invention

Hereinbelow, an embodiment of this invention will be described in detail with reference to the drawing.

Fig. 1 shows an example of a schematic structure of a plasma treatment apparatus 10 for use in this invention. The plasma treatment apparatus 10 has a treatment container 11 provided with a substrate holding platform 12 for holding a SiC wafer W as a substrate to be treated. Gas within the treatment container 11 is exhausted from exhaust ports 11A and 11 B through a non-illustrated exhaust pump. The substrate holding platform 12 has a heater function for heating the SiC wafer W. A gas baffle plate (partition plate) 26 made of aluminum is disposed around the substrate holding platform 12. A quartz cover 28 is provided on an upper surface of the gas baffle plate 26.

The treatment container 11 is provided, in the apparatus upper part thereof, with an opening portion corresponding to the SiC wafer W on the substrate holding platform 12. This opening portion is closed by a dielectric plate 13 made of quartz or Al₂O₃. A planar antenna 14 is disposed on the upper side of the dielectric plate 13 (on the outer side of the treatment container 11). The planar antenna 14 is formed with a plurality of slots for allowing an electromagnetic wave supplied from a waveguide to pass therethrough. A wavelength shortening plate 15 and the waveguide 18 are disposed on the further upper side (outer side) of the planar antenna 14. A cooling plate 16 is disposed on the outer side of the treatment container 11 so as to cover the upper part of the wavelength shortening plate 15. A coolant path 16a where a coolant flows is provided inside the cooling plate 16.

An inner side wall of the treatment container 11 is provided with a gas supply port 22 for introducing gases at the time of a plasma treatment. The gas supply port 22 may be provided for each of the gases to be introduced. In this case, a non-illustrated flow controller is provided per supply port as flow rate adjusting means. On the other hand, the gases to be introduced are mixed together in advance and then delivered so that the supply port 22 may be a single nozzle. Although not illustrated also in this case, the flow rate adjustment of the gases to be introduced is carried out by the use of flow rate adjusting valves or the like in the mixing stage. Further, a coolant flow path 24 is formed on the inner side of the inner wall of the treatment container 11 so as to surround the whole container.

The plasma substrate treatment apparatus 10 used in this invention is provided with a non-illustrated electromagnetic wave generator that generates an electromagnetic wave with several GHz for exciting a plasma. The microwave generated by this electromagnetic wave generator propagates in the waveguide 15 so as to be introduced into the treatment container 11.

When forming a gate insulating film (oxide film) on the SiC substrate by the use of the plasma treatment apparatus 10 having the foregoing structure, the SiC wafer W is first introduced into the treatment container 11 and set on the substrate holding platform 12. Thereafter, the air inside the treatment container 11 is exhausted through the exhaust ports 11A and 11 B so that the inside of the treatment container 11 is set to a predetermined treatment pressure. Then, an inert gas and an oxygen gas and/or a nitrogen gas are supplied from the gas supply port 22. As the inert gas, use is made of at least one of krypton (Kr), argon (Ar), and xenon (Xe).

Particularly, a combination of the oxygen gas and krypton (Kr) is preferable. This is because oxygen radicals and krypton (Kr) during film formation remain in a formed oxide film to thereby improve the properties (insulating property, interface property) as the insulating film. Note that, in the case of a thermal oxidation technique, krypton (Kr) does not remain in an oxide film.

On the other hand, the microwave with a frequency of several GHz generated by the electromagnetic wave generator is supplied to the treatment container 11 passing through the waveguide 15. The microwave is introduced into the treatment container 11 through the planar antenna 14 and the dielectric plate 13. A plasma is excited by the microwave so that radicals are produced. The temperature of the SiC wafer in the plasma treatment is 600°C or less. The high-density plasma produced by the microwave excitation in the treatment container 11 forms an insulating film such as an oxide film on the SiC wafer W.

As a kind of insulating film, use can be made of an oxide film, a nitride film, an oxynitride film, or the like. Although the insulating film is directly formed on the SiC wafer W by the plasma (radicals) in the foregoing example, it is also possible to form an insulating film by a CVD (Chemical Vapor Deposition) method. Alternatively, it is possible to form an oxide film, a nitride film, or an oxynitride film by direct oxidation, direct nitriding, or direct oxynitriding of the plasma and then by plasma CVD. This facilitates an adjustment of the thickness of the insulating film. A semiconductor device of this invention is particularly suitable for a power device requiring a high withstand voltage and enables a thickness of the insulating film of about 300nm (=3000Å).

The semiconductor device manufactured as described above has the insulating film excellent in all plane orientations, thereby enabling suppression of an increase in interface states and possessing excellent device properties.

While the embodiment of this invention has been described on the basis of some examples, this invention is not to be limited to those examples in any aspect, but can be modified within the category of technical thoughts as defined in the scope of claims.

## Claims

1. A semiconductor device **characterized by** comprising
a semiconductor substrate made of SiC; and
an insulating film formed on said semiconductor substrate,
wherein said insulating film is formed by a plasma treatment and contains a rare gas at least partly.

2. A semiconductor device according to claim 1, **characterized in that** said insulating film includes a gate insulating film.

3. A semiconductor device according to claim 1 or 2, **characterized in that** said insulating film contains at least one of krypton (Kr), argon (Ar), and xenon (Xe) as the rare gas.

4. A semiconductor device according to any of claims 1, 2, and 3, **characterized in that** at least part of said insulating film is one of an oxide film, an oxynitride film, and a nitride film.

5. A semiconductor device according to any of claims 1, 2, 3, and 4, **characterized in that** SiC forming said semiconductor substrate is a single crystal.

6. A semiconductor device according to any of claims 1, 2, 3, 4, and 5, **characterized in that** said insulating film is formed by the plasma treatment where a temperature of the substrate is 600°C or less.

7. A semiconductor device according to any of claims 1, 2, 3, 4, 5, and 6, **characterized in that** said insulating film is formed by one of direct oxidation, direct nitriding, and direct oxynitriding of a microwave-excited plasma.

8. A semiconductor device according to any of claims 1, 2, 3, 4, 5, and 6, **characterized in that** said insulating film includes at least one of an oxide film, a nitride film, and an oxynitride film formed by microwave-excited plasma CVD.

9. A semiconductor device according to any of claims 1, 2, 3, 4, 5, and 6, **characterized in that** said insulating film includes at least one of an oxide film, a nitride film, and an oxynitride film formed by one of direct oxidation, direct nitriding, and direct oxynitriding of a microwave-excited plasma and then by microwave-excited plasma CVD.

10. A semiconductor device **characterized by** comprising
a semiconductor substrate made of single-crystal SiC; and
an insulating film including a gate insulating film formed on said semiconductor substrate,
wherein said insulating film is formed by a plasma treatment,
said insulating film contains at least one of krypton (Kr), argon (Ar), and xenon (Xe) as a rare gas,
at least part of said insulating film is one of an oxide film, an oxynitride film, and a nitride film, and
said insulating film is formed by one of direct oxidation, direct nitriding, and direct oxynitriding of a microwave-excited plasma under a condition where a temperature of the substrate is 600°C or less.

11. A semiconductor device **characterized by** comprising
a semiconductor substrate made of single-crystal SiC; and
an insulating film including a gate insulating film formed on said semiconductor substrate,
wherein said insulating film is formed by a plasma treatment,
said insulating film contains at least one of krypton (Kr), argon (Ar), and xenon (Xe) as a rare gas,
at least part of said insulating film is one of an oxide film, an oxynitride film, and a nitride film, and
said insulating film is formed by one of oxidation, nitriding, and oxynitriding by microwave-excited plasma CVD under a condition where a temperature of the substrate is 600°C or less.

12. A semiconductor device **characterized by** comprising
a semiconductor substrate made of single-crystal SiC; and
an insulating film including a gate insulating film formed on said semiconductor substrate,
wherein said insulating film is formed by a plasma treatment,
said insulating film contains at least one of krypton (Kr), argon (Ar), and xenon (Xe) as a rare gas,
at least part of said insulating film is one of an oxide film, an oxynitride film, and a nitride film, and
said insulating film is formed, under a condition where a temperature of the substrate is 600°C or less, by one of direct oxidation, direct nitriding, and direct oxynitriding of a microwave-excited plasma and then by one of oxidation, nitriding, and oxynitriding by microwave-excited plasma CVD.

13. A semiconductor device manufacturing method **characterized by** forming an insulating film by a plasma treatment on a semiconductor substrate made of SiC.

14. A semiconductor device manufacturing method according to claim 13, **characterized in that** said insulating film includes a gate insulating film.

15. A semiconductor device manufacturing method according to claim 13 or 14, **characterized by** using at least one of krypton (Kr), argon (Ar), and xenon (Xe) as a rare gas when forming said insulating film.

16. A semiconductor device manufacturing method according to any of claims 13, 14, and 15, **characterized in that** at least part of said insulating film is one of an oxide film, an oxynitride film, and a nitride film.

17. A semiconductor device manufacturing method according to any of claims 13, 14, 15, and 16, **characterized in that** SiC forming said semiconductor substrate is a single crystal.

18. A semiconductor device manufacturing method according to any of claims 13, 14, 15, 16, and 17, **characterized by** forming said insulating film by the plasma treatment where a temperature of the substrate is 600°C or less.

19. A semiconductor device manufacturing method according to any of claims 13, 14, 15, 16, 17, and 18, **characterized by** forming said insulating film by one of direct oxidation, direct nitriding, and direct oxynitriding of a microwave-excited plasma.

20. A semiconductor device manufacturing method according to any of claims 13, 14, 15, 16, 17, and 18, **characterized in that** said insulating film is one of an oxide film, a nitride film, and an oxynitride film formed by microwave-excited plasma CVD.

21. A semiconductor device manufacturing method according to any of claims 13, 14, 15, 16, 17, and 18, **characterized in that** said insulating film is one of an oxide film, a nitride film, and an oxynitride film formed by one of direct oxidation, direct nitriding, and direct oxynitriding of a microwave-excited plasma and then by microwave-excited plasma CVD.

22. A semiconductor device manufacturing method for forming an insulating film including a gate insulating film by a plasma treatment on a semiconductor substrate made of single-crystal SiC, said method **characterized by**
using at least one of krypton (Kr), argon (Ar), and xenon (Xe) as a rare gas when forming said insulating film,
at least part of said insulating film being one of an oxide film, an oxynitride film, and a nitride film, and
forming said insulating film by one of direct oxidation, direct nitriding, and direct oxynitriding of a microwave-excited plasma under a condition where a temperature of the substrate is 600°C or less.

23. A semiconductor device manufacturing method for forming an insulating film including a gate insulating film by a plasma treatment on a semiconductor substrate made of single-crystal SiC, said method **characterized by**
using at least one of krypton (Kr), argon (Ar), and xenon (Xe) as a rare gas when forming said insulating film,
at least part of said insulating film being one of an oxide film, an oxynitride film, and a nitride film, and
forming said insulating film by one of oxidation, nitriding, and oxynitriding by microwave-excited plasma CVD under a condition where a temperature of the substrate is 600°C or less.

24. A semiconductor device manufacturing method for forming an insulating film including a gate insulating film by a plasma treatment on a semiconductor substrate made of single-crystal SiC, said method **characterized by**
using at least one of krypton (Kr), argon (Ar), and xenon (Xe) as a rare gas when forming said insulating film,
at least part of said insulating film being one of an oxide film, an oxynitride film, and a nitride film, and
forming said insulating film, under a condition where a temperature of the substrate is 600°C or less, by one of direct oxidation, direct nitriding, and direct oxynitriding of a microwave-excited plasma and then by one of oxidation, nitriding, and oxynitriding by microwave-excited plasma CVD.
